Europäisches Patentamt

European Patent Office

Office européen des brevets

(11) Veröffentlichungsnummer: **0 215 261**
**A2**

## (12) EUROPÄISCHE PATENTANMELDUNG

(21) Anmeldenummer: **86110693.8**

(51) Int. Cl.⁴: **G 02 C 1/04**

(22) Anmeldetag: **02.08.86**

(30) Priorität: **10.09.85 CH 3899/85**

(71) Anmelder: **BALZERS AKTIENGESELLSCHAFT, FL-9496 Balzers (LI)**

(43) Veröffentlichungstag der Anmeldung: **25.03.87**
**Patentblatt 87/13**

(84) Benannte Vertragsstaaten: **AT BE CH DE FR GB LI NL SE**

(72) Erfinder: **Göldi, Toni, Egerta 386, FL-9496 Balzers (LI)**

(54) **Linsenhalterung, insbesondere Halterung für zu reinigende und nachfolgend zu beschichtende Brillenglaslinsen.**

(57) Die insbesondere für zu reinigende und nachfolgend zu beschichtende Brillenglaslinsen bestimmte Halterung besitzt die Form eines Ringes, der an seiner Innenseite Gabeln zur Aufnahme der zu haltenden Linsen aufweist. Gemäß Erfindung ist der Ring elastisch verformbar und sind die Gabeln an zwei einander gegenüberliegenden Abschnitten der Ringinnenseite angeordnet. Das ermöglicht ein arbeitssparendes Einspannen – sogar mit bloß einer Hand – der Linsen, erlaubt eine große Durchmessertoleranz, und die Verwendung ein- und derselben Haltevorrichtung für mehrere Arbeitsvorgänge.

LINSENHALTERUNG, INSBESONDERE HALTERUNG FUER ZU REINIGENDE UND NACH-
FOLGEND ZU BESCHICHTENDE BRILLENGLASLINSEN.

Die vorliegende Erfindung betrifft eine Linsenhalterung, insbesondere
für zu reinigende und nachfolgend zu beschichtende Brillenglaslinsen.

Es sind verschiedene Haltevorrichtungen für die Halterung von Linsen bekannt, welche diese an ihrem Rand fassen, wobei die Haltevorrichtungen
nach Beladung z.B. in eine Reinigungs- oder Beschichtungseinrichtung eingesetzt werden können. Probleme ergeben sich jedoch immer wieder dadurch,
dass die Linsenflächen nicht vollständig bis zum Rand beschichtet werden
können, weil die Haltevorrichtungen die zu beschichtenden Flächen stellenweise abdecken und also an diesen Stellen die Beschichtung verhindern.

Besonders bei Brillengläsern, bei denen nicht nur auf die technisch einwandfreie Wirkung einer Beschichtung sondern auch auf das Aussehen derselben grossen Wert gelegt wird, fällt dieser Mangel ins Gewicht.

Eine bekannte Vorrichtung (GB-PS 662 762) verwendet für die Halterung von
Linsen auf einer optischen Bank federnde Gabeln, die mit ihren beiden Armen die Linse an ihrem Rand fassen und festhalten. Eine weitere bekannte
Linsenhalterung (GB-PS 655 856) besitzt die Form eines Ringes an dessen
Innenseite drei schwenkbare, mit Nuten versehene Arme angebracht sind,
die dank ihrer Schwenkbarkeit Linsen verschiedener Grösse am Rande fassen
und festhalten können. Diese Haltevorrichtungen haben den Nachteil, dass
zum Einsetzen einer Linse, z.B. eines Brillenglases, beide Hände gebraucht
werden, wobei mit der einen Hand die einzusetzende Linse gehalten und mit
der anderen die Haltevorrichtung geöffnet bzw. nach dem Einsetzen wieder
geschlossen wird. Für die fabrikationsmässige Verarbeitung z.B. Reinigung
oder Beschichtung ist eine solche Arbeitsweise umständlich und ausserdem
sind bekannte Haltevorrichtungen wegen in ihrer Konstruktion oft aufwendig
und verteuern auch dadurch die Bearbeitung der Linsen sehr.

Es sind Beschichtungsanlagen bekannt, bei denen die Haltevorrichtungen als
ebene Platten mit Ausnehmungen für die zu beschichtenden Substrate ausgebildet sind, wobei mehrere solcher Platten in ein Drehgestell eingesetzt
werden können und zusammen eine sogenannte Kalotte bilden. Haltevorrichtungen dieser Art sind im allgemeinen nur für eine bestimmte Beschichtungs-

0215261

anlage geeignet, und Arbeitsvorgänge vor oder nach der Beschichtung erfordern deshalb gewöhnlich ein Umladen des zu behandelnden Gutes auf andere Träger, welche für die Weiterbearbeitung in anderen Geräten geeignet sind. Das Umladen bedeutet aber für einen Fabrikationsprozess einen zusätzlichen Aufwand an Arbeitszeit und stellt deshalb einen nicht unbedeutenden Kostenfaktor dar.

Da die einzelnen zu behandelnden Linsen oft wechselnde Grössen besitzen, werden meist der jeweiligen Grösse der Substrate angepasste Einzelträger verwendet, die ihrerseits in die für diese Träger passend ausgestalteten Haltevorrichtungen eingesetzt werden können, und letztere sind auf die Anlage, in welcher die Beschichtung oder ein anderer Arbeitsvorgang durchgeführt wird, abgestimmt. Es ist klar, dass das Arbeiten mit einem solchen System von ineinander geschachtelten Trägern bzw. Haltevorrichtungen einen besonders grossen Arbeitsaufwand bedeutet.

Die vorliegende Erfindung hat sich zur Aufgabe gestellt, eine Halterung der eingangs erwähnten Art anzugeben, welche ein arbeitssparendes Einspannen von Linsen mit grosser Durchmessertoleranz ermöglicht und gleichzeitig eine möglichst grossflächige Behandlung (z.B. Beschichtung) derselben zulässt; eine weitere Arbeitsersparnis durch nur einmaliges Einspannen und Verwendbarkeit ein- und derselben Haltevorrichtung für mehrere Arbeitsvorgänge ist ein weiteres Ziel der Erfindung.

Diese erfindungsgemässe Linsenhalterung, insbesondere Halterung für zu reinigende und nachfolgend zu beschichtende Brillenglaslinsen, welche als ein an seiner Innenseite Gabeln zur Aufnahme der zu haltenden Linsen tragender Ring ausgebildet ist, ist dadurch gekennzeichnet, dass der Ring elastisch verformbar ist und die Gabeln an zwei einander gegenüberliegenden Abschnitten der Ringinnenseite angeordnet sind.

Man erreicht dadurch nicht nur eine erhöhte Flexibilität in der Anwendbarkeit der Halterung, indem, wie gesagt, die gleiche Halterung für Linsen mit grossen Durchmesserschwankungen (wie sie z.B. bei Brillenglaslinsen mit noch nicht fertig zugeschliffenem Rand vorkommen) verwendet werden kann, sondern auch eine vereinfachte Handhabung dadurch, dass diese Halterungen nacheinander in verschiedene Bearbeitungsstationen eingesetzt werden können. Man erhält darüber hinaus aber noch Vorteile, vor allem bei der Brillenglasbeschichtung, z.B. gestaltet die neue Halterung das Wenden der Linsen, um ggf. beide Seiten zu beschichten und vor allen wird eine weitestgehend abschattungsfreie randlose Beschichtung ermöglicht.

Anliegend wird die Erfindung anhand der beiliegenden Zeichnung noch näher erläutert. In dieser zeigt:

Figur 1 eine Draufsicht auf das Ausführungsbeispiel;

Figur 2 eine seitliche Ansicht nach der Linie $\overline{AA}$ der Figur 1.

0215261

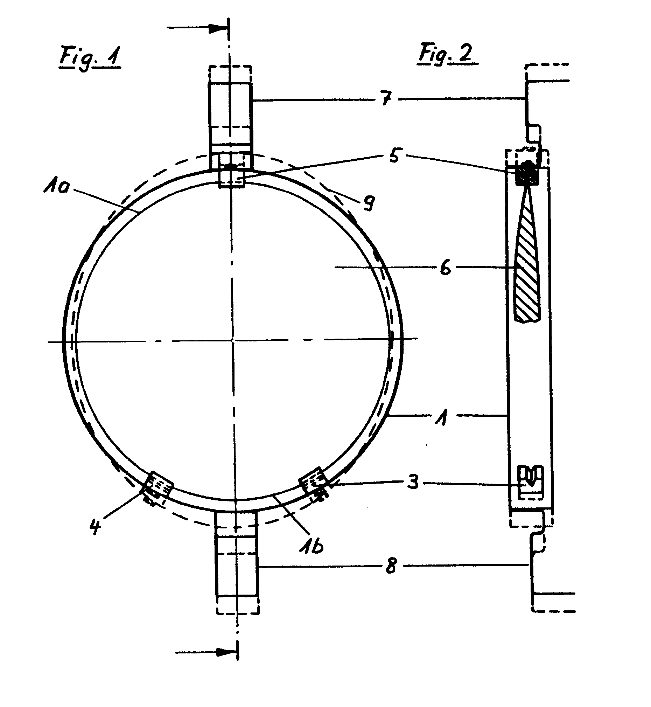

In der Zeichnung bedeutet 1 einen Federring, hergestellt z.B. aus federndem Stahlband, an dessen Innenseite die drei Gabeln 3, 4 und 5 angeschweisst, angeschraubt oder sonstwie befestigt sind. Diese Gabeln sind - wie die Figur 2 erkennen lässt - dem Rand der jeweils aufzunehmenden Linse 6 entsprechend geformt;im Beispielsfalle, welcher das Halten einer Linse mit scharfkantigem Rand illustriert, sind die Gabeln als mit einer entsprechenden Nut versehenes Einsatzstück mit zwei an die Linsenränder beidseitig anliegenden Backen ausgebildet. Das (in der Zeichnung) obere und untere Ende des Ringes 1 ist mit zum Einsetzen der Halterung z.B. in eine Waschanlage, Beschichtungsanlage oder eine andere Bearbeitungsvorrichtung geeigneten Endstücken versehen, welche im vorliegenden Ausführungsbeispiel aus Blechfahnen 7 und 8 bestehen. (Selbsverständlich müssen auch die Aufnahmevorrichtungen in der betreffenden Bearbeitungsstation eine dazupassende Form besitzen).

Um nun eine Linse in die beschriebene Halterung einzusetzen, wird der Ring 1 mit der Hand seitlich etwas zusammengedrückt, so dass er eine länglichovale Form erhält; diese ist in Figur 1 durch die unterbrochene Linie 9 angedeutet. Dadurch entfernen sich die an den zwei gegenüberliegenden Abschnitten 1a und 1b des Ringes 1 angebrachten Gabeln so weit voneinander, dass die z.B. auf einem Arbeitstisch liegende Linse (die natürlüch einen kleineren Durchmesser als der Ring besitzen muss) zwischen die Gabeln eingeführt werden kann. Wenn der Ring sodann wieder losgelassen wird, versucht er in seine ursprüngliche Form zurückzukehren. Dadurch nähern sich die beiden Abschnitte 1a und 1b einander wiederum und die Gabeln pressen sich infolge des Federdruckes an den Linsenrand an. Die Linse ist somit in die Halterung aufgenommen und kann mit ihr zusammen transportiert werden.

Dank der Elastizität des Ringes können sich die Gabeln leicht Abweichungen von der idealen Form der Linse anpassen, d.h. diese braucht weder genau kreisrund zu sein noch einen präzisen Durchmesser aufweisen, was insbesonders für die in zunehmendem Masse verwendeten Brillenglaslinsen aus Kunststoff von grossem Vorteil ist. Auch durch Temperaturerhöhungen (wie sie z.B. während der Bedampfung in einer Beschichtungsanlage auftreten können) bedingte Grössenveränderungen werden durch die federnd gehaltenen Gabeln ohne weiteres ausgeglichen.

Die Oberfläche des Ringes und der Gabeln sollte möglichst frei von Löchern und Hohlräumen sein, um in den Wasch- und Reinigungsanlagen mit mehreren Trögen das Verschleppen von in etwaigen Hohlräumen und Vertiefungen abgesetzten Chemikalien möglichst zu vermeiden.

Es ist klar, dass die Einzelheiten des beschriebenen Ausführungsbeispiels abgewandelt werden können, ohne vom Grundgedanken der Erfindung abzuweichen. Die Endstücke 7 und 8 können auch anders (z.B. in an sich bekannter Weise als Teile von Befestigungseinrichtungen) ausgebildet werden. Ebenso können die Gabeln abgewandelt im Einzelfalle den jeweiligen Umständen

0215261

angepasst werden. Die im Ausführungsbeispiel gezeigte  Form, bei welcher drei Gabeln vorgesehen sind, von denen eine an einem ersten und die beiden anderen an einem dem ersten Abschnitt gegenüberliegenden Abschnitt der Ringinnenseite angeordnet sind, hat sich als besonders vorteilhaft erwiesen, weil dadurch eine sehr stabile Dreipunkthalterung der Linsen erreicht

wird.

PR 8557

- 1 -

0215261

PATENTANSPRUECHE

1. Linsenhalterung, insbesondere Halterung für zu reinigende und nachfolgend zu beschichtende Brillenglaslinsen, welche als ein an seiner Innenseite Gabeln zur Aufnahme der zu haltenden Linsen tragender Ring ausgebildet ist, d a d u r c h  g e k e n n z e i c h -
n e t, dass der Ring elastisch verformbar ist und die Gabeln an
zwei einander gegenüberliegenden Abschnitten der Ringinnenseite
angeordnet sind.

2. Linsenhalterung nach Anspruch 1, d a d u r c h  g e k e n n -
z e i c h n e t, dass drei Gabeln vorgesehen sind, von denen eine
an einem ersten und die beiden anderen an einem dem ersten Abschnitt gegenüberliegenden Abschnitt der Ringinnenseite angeordnet
sind.

PR 8557

Fig. 1    Fig. 2    0215261    1/1